(19) Europäisches Patentamt

European Patent Office

Office européen des brevets

(11) Numéro de publication: **0 112 780**
A1

(12) **DEMANDE DE BREVET EUROPEEN**

(21) Numéro de dépôt: 83402508.2

(22) Date de dépôt: 22.12.83

(51) Int. Cl.³: **C 03 C 17/245**

(30) Priorité: 23.12.82 JP 230376/82

(43) Date de publication de la demande: 04.07.84
Bulletin 84/27

(84) Etats contractants désignés: **AT BE CH DE FR GB IT LI LU NL SE**

(71) Demandeur: **SAINT-GOBAIN VITRAGE, Les Miroirs 18, avenue d'Alsace, F-92400 Courbevoie (FR)**

(72) Inventeur: **Kato, Yukihiro, 2-1-403 Nigawa-cho 2-chome, Nishinomiya-shi Hyogo-ken (JP)**
Inventeur: **Kawahara, Hideo, 8-3-205 Minami Sakurazuda 2-chome, Toyonak-shi Osaka-fu (JP)**
Inventeur: **Hyodo, Masato, 21, Nakano Higashi 3-chome, Itami-shi Hyogo-ken (JP)**

(74) Mandataire: **Breton, Jean-Claude et al, SAINT-GOBAIN RECHERCHE 39, quai Lucien Lefranc, F-93304 Aubervilliers (FR)**

(54) Procédé de dépôt d'une couche d'oxyde d'étain sur un substrat à partir de composés d'étain à l'état gazeux.

(57) La présente invention concerne le dépôt d'une couche transparente d'oxyde d'étain sur la surface d'un substrat en verre, céramique, métal ou autres matières.

Elle consiste à mettre en contact la vapeur obtenue par chauffage de monobutyl trichlorure d'étain, mélangée ou non avec un autre composé à l'état gazeux, tel que le dichlorodifluorométhane, avec un substrat chauffé à haute température.

Application dans le domaine des conducteurs transparents (verres anti-buée) ou des capteurs solaires.

TAUX DE TROUBLE (%)

EPAISSEUR DE LA COUCHE (Å)

o $C_4H_9SnCl_3$

◇ $SnCl_4$

△ $(CH_3)_2SnCl_2$

EP 0 112 780 A1

ACTORUM AG

PROCEDE DE DEPOT D'UNE COUCHE D'OXYDE D'ETAIN SUR UN SUBSTRAT

A PARTIR DE COMPOSES D'ETAIN A L'ETAT GAZEUX

La présente invention concerne le dépôt d'une couche d'oxyde d'étain sur la surface d'un substrat en verre, céramique, métal ou autres matières.

Plus précisément, elle porte sur une méthode de dépôt d'une couche d'oxyde d'étain par la mise en contact de composés organiques d'étain à l'état gazeux avec la surface d'un substrat en verre, céramique, métal ou autres matières, chauffé à une haute température. En général, la couche d'oxyde d'étain étant très dure, elle est utilisée largement pour éviter la détérioration de la surface des vaisselles, bouteilles, etc... Par ailleurs, il y a de nombreuses applications profitant du caractère semi-conducteur de la couche d'oxyde d'étain ; par exemple, des verres revêtus d'une telle couche sont largement employés comme conducteurs transparents tels qu'électrodes pour des cristaux liquides, verres anti-buée, etc... Egalement, des plaquettes céramiques fines revêtues d'une couche d'oxyde d'étain sont extrêmement employées en tant que pièces électriques. En plus, en profitant du caractère réflecteur des rayons infra-rouges de la couche d'oxyde d'étain, des verres ou tubes métalliques revêtus d'une couche d'oxyde d'étain sont utilisés comme couvercles ou tubes de capteurs solaires.

Il existe plusieurs méthodes pour déposer une couche d'oxyde d'étain sur la surface d'un substrat en verre, céramique, métal ou autres matières. Comme méthode appropriée pour la fabrication en série, on utilise depuis longtemps la méthode qui consiste à pulvériser une solution de tétrachlorure d'étain sur la surface du substrat maintenu à haute température. Depuis quelques années, on utilise également la méthode dite "CVD" (Coating Vapor Deposition), qui consiste à mettre en contact la vapeur obtenue par chauffage et vaporisation de tétrachlorure d'étain ou de diméthyl dichlorure d'étain, avec un substrat en verre, céramique, métal ou autres matières, chauffé à haute température.

Toutefois, les couches d'oxyde d'étain ainsi obtenues présentent par endroit des zones troubles d'aspect légèrement laiteux. Ce défaut est d'autant plus marqué que la couche d'oxyde d'étain est plus épaisse.

Pour atténuer cet inconvénient un certain nombre de modifications ont été apportées notamment aux dispositifs de pulvérisation de la solution de composés d'étain, ou aux dispositifs projetant la vapeur desdits composés.

Le nombre de zones troubles peut être considérablement réduit en utilisant d'autres composés organiques, tel que le dibutyl diacétate d'étain, mais cet avantage est contrebalancé par plusieurs inconvénients.

Ainsi, lorsqu'on utilise le dibutyl diacétate d'étain la couche d'oxyde d'étain se forme bien plus lentement qu'avec le diméthyl dichlorure d'étain ou le tétrachlorure d'étain. D'autre part, le dibutyl diacétate d'étain a tendance à se dissocier lorsqu'on le chauffe pour l'obtenir à l'état de vapeur ; il s'ensuit que la quantité de vapeur produite peut varier dans de fortes proportions.

La présente invention vise un procédé de dépôt d'une couche d'oxyde d'étain qui se caractérise par une grande vitesse de dépôt tout en conservant en grande transparence à ladite couche, quelle que soit son épaisseur.

La présente invention a également pour objet un procédé permettant d'obtenir une couche d'oxyde d'étain dont la résistance électrique est faible.

Pour cela elle propose d'employer comme composé organique le monobutyl trichlorure d'étain, $C_4H_9SnCl_3$, composé qui ne se dissocie pas facilement sous l'action de la chaleur et qui permet d'obtenir rapidement une couche d'oxyde d'étain d'excellente qualité.

Ce composé à l'état gazeux peut être mélangé à un autre composé à l'état gazeux, ce dernier contenant un élément susceptible d'être incorporé dans la couche d'oxyde d'étain.

0112780

- 3 -

Les avantages de l'invention seront mieux perçus au travers des exemples suivants et des figures jointes qui représentent :

- figure 1 : un schéma du dispositif qui permet de vaporiser le composé d'étain et de le mettre en contact avec le substrat chauffé,

- figure 2 : une représentation graphique indiquant l'épaisseur de la couche d'oxyde d'étain obtenue en fonction du temps et du composé d'étain choisi,

- figure 3 : une représentation graphique de la variation du taux de trouble de la couche d'oxyde d'étain en fonction de son épaisseur et selon le composé d'étain utilisé pour l'obtenir,

- figure 4 : une représentation graphique de la variation de la résistance électrique de la couche d'oxyde d'étain en fonction de son épaisseur et du composé d'étain choisi pour l'obtenir.

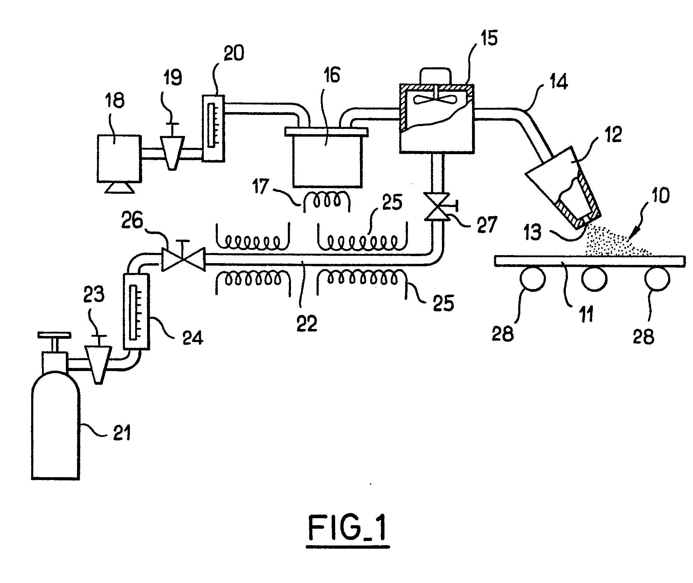

Comme le montre la figure 1, qui représente le dispositif de mise en oeuvre de la méthode "CVD", la vapeur 10 du ou des composés choisis est projetée contre la surface du substrat 11 par l'intermédiaire d'un ajutage 12 muni d'une fente 13. Cet ajutage est relié par l'intermédiare d'une tubulure 14 à une chambre 15 servant à mélanger les gaz utilisés. Cette chambre 15 est reliée par une tubulure à un évaporateur 16 contenant le composé d'étain, chauffé par une résistance 17. La vapeur du composé d'étain est entraînée par un gaz vecteur provenant d'un compresseur 18, la pression et le débit dudit gaz étant réglés par le détendeur 19 et le débitmètre 20. La chambre 15 est reliée également à un réservoir 21 contenant un produit fluoré sous pression par l'intermédiaire d'une tubulure 22. La pression et le débit du composé fluoré gazeux sont réglés par le détendeur 23 et le débitmètre 24. La tubulure 22, chauffée sur la majeure partie de sa longueur par des résistances chauffantes 25, est munie de vannes 26 et 27.

La projection de la vapeur 10 est effectuée alors que le substrat 11 est déplacé sur des rouleaux 28.

### PREMIERE SERIE D'EXEMPLES COMPARATIFS

Le substrat choisi est une plaque de verre de 150 mm de largeur, 400 mm de longueur et de 5 mm d'épaisseur. Cette plaque est déplacée sur les rouleaux 28 à la vitesse de 1 m/min et la température de la surface du verre est alors d'environ 575°C.

Le composé d'étain choisi est le monobutyl trichlorure d'étain, $C_4H_9SnCl_3$, porté à 150°C dans l'évaporateur 16. L'azote sert de gaz vecteur délivré sous une pression de 1 $kg/cm^2$ et selon un débit de 50 l/min.

Dans ces conditions des couches d'oxyde d'étain ont été déposées toutes les 10 minutes pendant 1 heure.

Des couches d'oxyde d'étain ont été également déposées sur d'autres plaques de verre, de mêmes dimensions que la précédente et dans les mêmes conditions, en utilisant du tétrachlorure d'étain $SnCl_4$, puis du dibutyl diacétate d'étain, $(C_4H_9)_2Sn(CH_3COO)_2$.

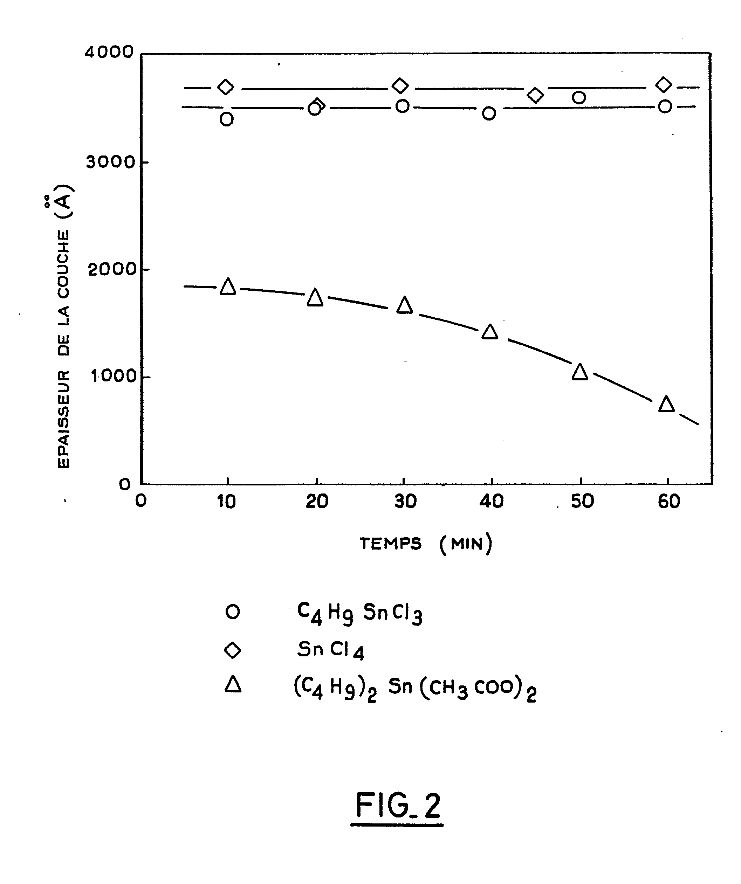

L'épaisseur des couches obtenues a été mesurée à l'aide d'un appareil appelé "TALLY SURF" ; les différents résultats recueillis sont représentés figure 2. Ces résultats montrent qu'en employant le monobutyl trichlorure d'étain, la vitesse de dépôt atteinte est pratiquement identique à celle obtenue avec le tétrachlorure d'étain, composé réputé pour la vitesse de dépôt élevée qu'il autorise.

Le dibutyl diacétate d'étain conduit par contre à une vitesse de dépôt beaucoup plus faible et qui décroît avec le temps.

DEUXIEME SERIE D'EXEMPLES COMPARATIFS

En reprenant les conditions définies dans la première série d'exemples, des couches d'étain ont été déposées en utilisant tout à tour le monobutyl trichlorure d'étain, le tétrachlorure d'étain et le diméthyl dichlorure d'étain, $(CH_3)_2SnCl_2$.

Le taux de trouble des couches d'oxyde d'étain ainsi obtenues a été déterminé par un appareil de mesure de brillance correspondant au modèle NDL-20H commercialisé par la société NIPPON DENSHOKU K.K. Comme précédemment, l'épaisseur des couches d'oxyde a été mesuré par l'appareil appelé "TALLY SURF".

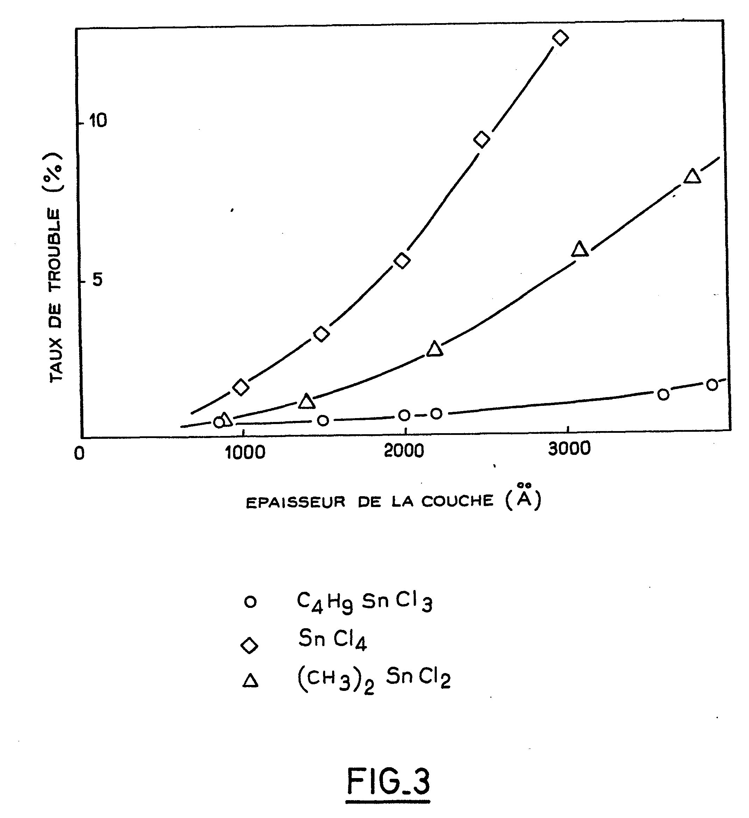

Les résultats obtenus sont représentés sur le graphique de la figure 3.

On constate que le monobutyl trichlorure d'étain permet de déposer une couche d'oxyde dont le taux de trouble reste très faible quelque soit l'épaisseur de ladite couche.

Il n'en est plus de même avec le diméthyl dichlorure d'étain pour lequel le taux augmente sensiblement avec l'épaisseur, ou avec le tétrachlorure d'étain pour lequel le taux de trouble augmente très rapidement dès que l'épaisseur de la couche dépasse 2000 $\overset{\circ}{A}$.

TROISIEME SERIE D'EXEMPLES COMPARATIFS

Dans cette série d'exemples les composés d'étain sont mélangés à un composé fluoré, à savoir le dichlorodifluorométhane $CCl_2F_2$.

Ce composé fluoré, sous pression dans le réservoir 21 représenté à la figure 1, arrive dans la chambre 15 selon un débit de 10 1/min.

- 5 -

Les conditions de dépôt des couches d'oxyde d'étain sont les mêmes que celles définies précédemment.

Ces couches ont été formées en utilisant tout à tour le monobutyl trichlorure d'étain, le diméthyl dichlorure d'étain, et le dibutyl diacétate d'étain.

La résistance électrique de ces différentes couches a été mesurée ainsi que leur épaisseur comme décrit précédemment.

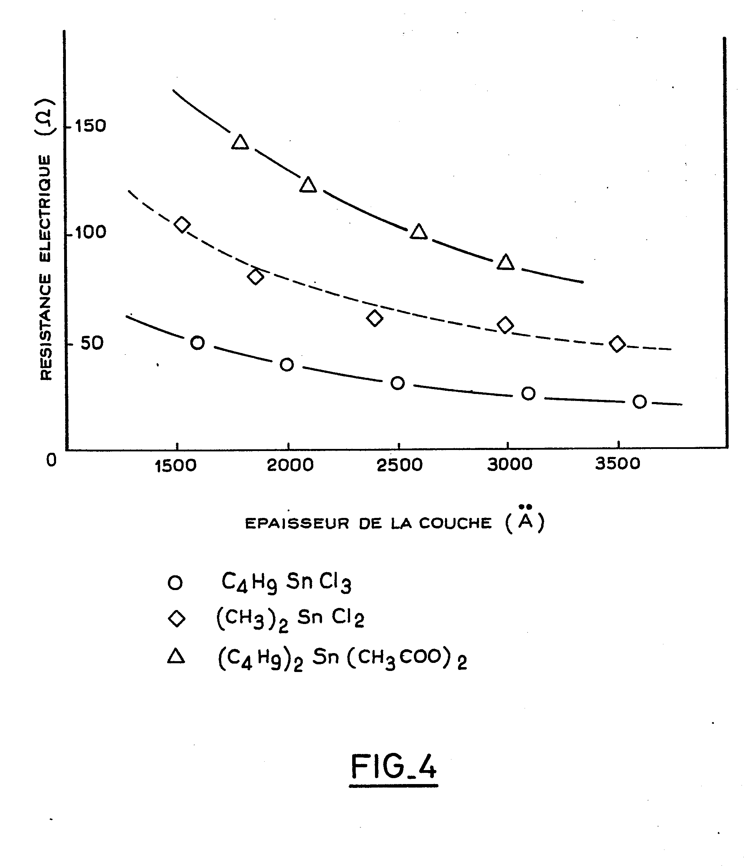

Les différents résultats obtenus sont reportés sur le graphique de la figure 4.

Ces résultats démontrent que le monobutyl trichlorure d'étain permet d'obtenir des couches d'oxyde d'étain dont là résistance électrique est beaucoup plus faible que celle des couches obtenues en employant les deux autres composés.

Il est bien évident que les conditions indiquées précédemment ne sont pas impératives.

Ainsi, il est possible de faire varier le débit du gaz vecteur entre 20 et 150 1/min sans altérer pour autant la qualité des couches d'oxyde d'étain obtenues.

De même, l'homme de l'art pourra associer au monobutyl trichlorure d'étain des composés fluorés autres que le dichlorodifluorométhane sans sortir du cadre de l'invention.

La description précédente montre que le monobutyl trichlorure d'étain présente les avantages des composés d'étain les plus performants, sans en comporter les inconvénients respectifs, et que son emploi améliore le procédé "CVD" de dépôt d'oxyde d'étain.

REVENDICATIONS

1. Procédé de dépôt d'une couche d'oxyde d'étain sur un substrat notamment en verre, d'après lequel on projette au moins un composé organique d'étain à l'état gazeux sur ledit substrat porté à haute température caractérisé en ce que ledit composé d'étain est le monobutyl trichlorure d'étain.

2. Procédé selon la revendication 1 caractérisé en ce qu'avant sa projection sur le substrat le composé d'étain à l'état gazeux est mélangé à un second composé à l'état gazeux contenant un élément susceptible de doper la couche d'oxyde d'étain obtenue.

3. Procédé selon la revendication 2, caractérisé en ce que le composé mélangé au monobutyl-trichlorure d'étain est un composé fluoré.

4. Procédé selon la revendication 3, caractérisé en ce que le composé fluoré est le dichlorodifluorométhane.

FIG.1

FIG. 2

FIG.3

FIG_4

**Office européen des brevets**

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X,Y | US-A-4 130 673 (W.A. LARKIN)<br>* Revendication 1; exemples 1,2 *<br><br>--- | 1-3 | C 03 C 17/245 |
| Y | EP-A-0 027 403 (SAINT GOBAIN VITRAGE)<br>* Revendication 1; exemple *<br><br>--- | 1-3 | |
| X | FR-A-2 323 649 (M. & T. INTERNATIONAL)<br>* Page 3, lignes 1-23; page 5, ligne 20 - page 6, ligne 15; exemples 1,2 *<br><br>----- | 1-3 | |

**DOMAINES TECHNIQUES RECHERCHES (Int. Cl. ³)**

C 03 C 17/00

Le présent rapport de recherche a été établi pour toutes les revendications

| Lieu de la recherche | Date d'achèvement de la recherche | Examinateur |
|---|---|---|
| LA HAYE | 15-02-1984 | BOUTRUCHE J.P.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503.03.82